# EUROPEAN PATENT APPLICATION

(11) **EP 2 716 792 A1**
(43) Date of publication of application: **09.04.2014**
(21) Application number: 12187384.8
(22) Date of filing: 05.10.2012
(51) Int. Cl.: C23C 16/48, H01J 37/317

(54) **Process for the manufacture of local nanostructures of high purity material**

(71) Applicant: FEI COMPANY, Hillsboro, Oregon 97124-5793 (US)
(72) Inventor: Mulders, Hans, 5632 SB Eindhoven (NL); Randolph, Steven, Portland, OR Oregon 97209 (US); Rue, Chad, Portland, OR Oregon 97229 (US); Chandler, Clive, Portland, OR Oregon 97212 (US)
(74) Representative: Bakker, Hendrik

(57) **Abstract**

A process for deposition of high purity metal or metal oxide nano layers comprising:
directing a precursor fluid toward a substrate surface, and irradiating the substrate surface with a focused ion beam in the presence of the precursor fluid, the precursor fluid dissociating in the presence of the particle beam to deposit a metal or metal oxide on the substrate surface, characterized in that the focused ion beam comprises hydrogen or oxygen ions, and shaped nano layers of high purity metal obtainable by said process.

## Description

### TECHNICAL FIELD

The present invention relates to a process for the manufacture of local nanostructures of high purity metal or metal oxide and to nanostructures obtained with it.

More in particular the invention relates to deposited metal or metal oxide in local nanostructures, the relevant parameters of interest of which (e.g. resistivity) do not deviate too much from related bulk properties of the same metal.

### BACKGROUND OF THE INVENTION

For a long time already several companies are trying to develop electron beam induced deposition (EBID) and ion beam induced deposition (IBID) techniques to create local nanostructures of metal.

These techniques can be used for the direct creation of a nanostructure in 2 or 3 dimensions.

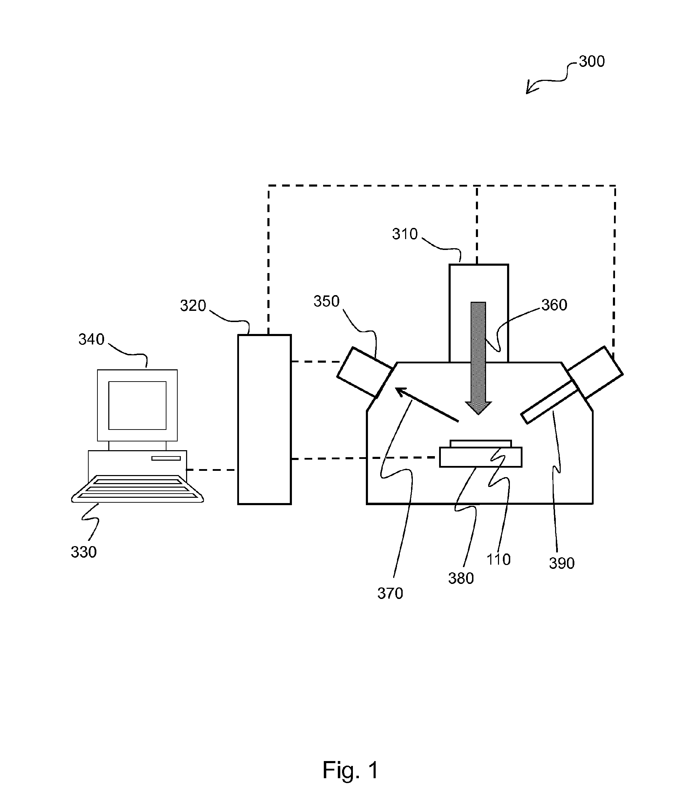

In Figure 1, a charged particle beam system 300 is schematically shown for use in the process of the present invention. The system 300 comprises:
- a charged particle column 310 generating a focused beam 360 of charged particles so as to irradiate a work piece110;
- a detector 350 for detecting radiation emanating from the work piece 110 in response to the irradiation with the focused beam, for example a detector for secondary electrons emitted from the work piece due to the impingement of an electron or ion beam. This may be used for characterization of the deposition during or after deposition. Alternatively, or in addition, the detector 350 may comprise an X-ray detector so that the EDX technique may be used for elemental characterization in combination with an appropriate particle beam setting.;
- a fluid injector 390 feeding a fluid, typically a gas, to the proximity of the work piece 110 surface;
- a work piece holder 380 for receiving and positioning the work piece 110;
- a control apparatus 320 to control the internal system environment, movement of the work piece holder 380, the charged particle beam source 310, the fluid injector 390, and to process signals from the detector 350;
- a user interface 330 for providing user input, and
- a display 340 for providing the user with visual information.

The work piece 110 to receive the deposited layer is selected depending on the application and purpose of the deposition. For example, semiconductor wafers of silicon, Si3N4, GaAs or Ge may be used. Other possibilities include biological samples, polymers, glass (SiO2) and ceramics.

The internal system environment is typically regulated in some way to reduce the risk of contamination and to reduce interaction between the charged particle beam and atmospheric gasses. For example, a reduced pressure may be used or even vacuum, vacuum levels being typically less than 10⁻⁵ mbar or better.

The fluid injector 390 typically comprises a control system to regulate the flow of the deposition fluid, and one or more guides inside the system 300 to ensure that a desired partial pressure of deposition fluid is achieved at the irradiation position. For example, a capillary tube having a small orifice is used to direct the fluid towards the work piece. The point of delivery may be made adjustable by incorporating manipulators.

The further configuration of the fluid injector 390 depends upon the fluid to be injected - it may comprise cooling and/or heating to achieve a certain temperature, it may comprise a reservoir for containing the deposition fluid or it may be in communication with a remote supply, it may comprise pressurization means to achieve a certain deposition gas pressure or flow rate.

The choice of precursor compound for injection depends mainly upon the material to be deposited. However, other important criteria include the ability to create a fluid form at reasonable temperatures, adequate adhesion of the deposited material to the work piece, stability at the fluidic temperature and the production of relatively few by-products.

Once injected, the molecules will temporarily adhere to the surface and within that residence time they may interact with electrons supplied by the electron beam or electrons generated by the impinging beam.

This interaction results in a decomposition of the precursor molecule into a volatile part, such as CO or a CH₄ group (that is pumped away by the vacuum system), and a deposition part, which forms nanostructures on the substrate.

By appropriate scanning of the beam during deposition, images may be produced using the deposited material. Alternatively a mask may be used to impart a pattern into beam for imaging on the work piece. These techniques are well known in the art.

The precursor material may be gas, liquid or solid. Liquid or solids are typically gasified prior to deposition, usually through fluidization or sublimation, and introduced, at accurately controlled rate, into the system chamber. Alternatively, solid precursor may be sublimated by the irradiation using a charged beam.

Typically the local flux of molecules is in the order of 10¹⁵-10¹⁹ molecules/cm².s, while beam currents are in the range from 50 pA to 1 nA. It is generally assumed that the secondary electrons with an energy < 50 eV, emitted from the substrate, are the main contributors to the decomposition process.

Ion Beam Induced Deposition (IBID) is very similar to EBID, with the mayor difference that a focused ion beam, usually 30 to 40 keV Ga⁺, is used instead of the electron beam.

In both techniques it is not the primary beam but the secondary particles (secondary electrons), which cause the deposition. Said processes were known from e.g. Wikipedia "Electron beam induced deposition".

Typical for the creation of a metallic structure is a precursor based organo-metallic compound, the fluid of which is used as a gas supply to the system. Many of these chemicals resemble the chemicals used in chemical vapor deposition (CVD) based processes, where decomposition is driven by collisions with the substrate at high temperatures (thermal decomposition).

Examples of precursor materials that are regularly and frequently used for EBID are listed in the next Table:

| **Precursor** | **short name/formula** | **deposition** |
|---|---|---|
| Methyl cyclo-pentadienyl platinum trimethyl | MeCₚPtMe₃ | platinum |
| Tungsten hexacarbonyl | W(CO)₆ | tungsten |
| Cobalt octacarbonyl | Co₂(CO)₈ | cobalt |
| Tetra ethyl ortho silicate | TEOS | SiO₂ |
| Dimethyl gold acetyl acetonate | Me₂Auacac | gold |
| 2,4,6,8-tetramethyl cyclotetrasiloxane | TMCTS | SiOₓ |
| Copper hexafluoro acetyl acetonate | Cu(hfac)₂ | copper |
| Palladium hexafluoro acetyl acetonate | Pd(hfac)₂ | palladium |
| Nickel dicyclopentadienyl | Ni(Cp)₂ | nickel |
| Cobalt tricarbonyl nitrosyl | Co(CO)₃NO | cobalt |
| Di iron nona carbonyl | Fe₂(CO)₉ | iron |

So far the success for EBID and IBID has been limited due to the generally low purity of the deposited metal. This low purity of the metal deposit sets a limit to the applicability. Even if the purity of the deposited metal is not too bad, the relevant parameter (e.g. resistivity) can deviate too much from related bulk properties (for example a factor 100 or 1000), such that application becomes difficult if not impossible.

A variety of strategies have been applied to enhance said purity and improve the local properties: gas mixing as TEOS (tetraethylorthosilicate) with water vapor or TMCTS (tetramethylcyclotetrasiloxane) with oxygen gas, the choice of precursor types away from carbon containing metal compounds or complexes (such as Pt(PF₃)₄) work at elevated substrate temperatures (e.g. improvement of W deposition from 35 at% to 55 at%).

Said applied techniques offered an overall improvement but may also cause new undesired problems such as release of fluorine and the corresponding etching.

One of the basic reasons for the lack of high purity has been the inability to create sufficient volatile molecules during the deposition process.

For example: MeCpPtMe₃ can be regarded as a standard platinum precursor. The reaction of its decomposition can be depicted by

C₉H₁₆Pt + electrons → C₅Pt + 4CH₄ + electrons

which after pump out of the CH₄ actually results in around 16 at% of Pt.

Heating the substrate up to 300°C did not change the chemical composition within the error bandwidth as the residual carbon cannot escape from the deposited metal, even if it might be released by breaking its chemical bond. This means that there is no volatility unless it can bind to, for example, oxygen or hydrogen to form CO, CO₂ or CH₄ respectively. In other words, the particular balance is missing. The same may be concluded for Me₂Auacac, for Pd(hfac)₂ and Cu(hfac)₂ and Ni(Cp)₂ as is known from the literature.

More in particular, processes using one of the precursors were known from e.g. Nanotechnology, 2011, Feb.4 22(5), Mulders J.J., Belova, L.M., Riazanova, A; Functional Nanoscience, Beilstein Symposium, May 17-21, 2010, Bozen, Italy, Towards Electron Beam Induced Deposition; Improvements for Nanotechnology, Mulders, J.J.L and Botman, A, published June 13, 2011.

The best results obtained so far are for Fe₂(CO)₉ and for Co₂(CO)₈ where it is possible to get 78 at% Fe and 100 at% Co respectively.

Also for Au(CO)Cl a > 95 at% Au can be obtained, while both Cl and CO are volatile components. Here the actual reaction is quite simple: for example Co₂(CO)₈ + electrons → 2Co + 8CO + electrons, and CO is fully volatile.

It will be appreciated that one of the main causes for low purity are the missing species to create volatile molecules.

It will be appreciated by persons skilled in this field of art, that in an electron beam induced deposition (EBID) process these molecules will have to be present in large quantities at the position of the deposition. In other words: in high densities. However, a local supply will not be easy and will require a very high flux to and hence a large chamber pressure increase and in the case of gas additional dissociation processes will be required before reaction with a precursor becomes effective.

Therefore there is still a need for an improved, highly efficient IBID or EBID process, resulting in high purity deposited nano layers showing improved relevant physical properties, such as a low resistivity, on shaped articles, and which can apply almost all carbon based precursors, which normally leave non volatile carbon-containing compounds behind in de deposition itself.

With the term "low resistivity" is meant a resistivity of less than 120 µΩ.cm and preferably of less than 50 µΩ.cm.

Therefore an object of the present invention is to provide said improved process.

Another object of the present invention is to provide deposited nano metal layers on shaped articles, showing improved relevant physical properties, in particular a resistivity of less than 120 µΩ.cm and preferably less than 50 µΩ.cm. More preferably the deposited material is Ohmic or has a resistivity of within a factor 5 of the bulk metal.

### SUMMARY OF THE INVENTION

As a result of extensive research and experimentation, an IBID process for the deposition of nano layers has surprisingly been found, comprising a direct supply from the focused ion beam (FIB) of hydrogen or oxygen (further indicated as hydrogen FIB or oxygen FIB respectively).

Accordingly the present invention relates to a process for deposition of high purity metal or metal oxide nano layers, comprising directing a precursor fluid toward a substrate surface, and irradiating the substrate surface with a focused ion beam in the presence of the precursor fluid, the precursor fluid dissociating in the presence of the particle beam to deposit a metal on the substrate surface, characterized in that the focused ion bean comprises hydrogen or oxygen ions.

### Detailed description of preferred embodiments

According to a preferred embodiment of the process of the present invention, the precursor consists of a metal compound or metal complex, wherein at least a part of the carbon atoms are straightly bound to other carbon atoms,

According to a more preferred embodiment of the present invention, the metal compound or metal complex comprises one or more alkyl groups, acetyl acetonate groups, cyclopentadienyl groups, β-diketonate groups, 2,2,6,6-tetramethyl heptane dionate groups or combinations thereof.

Preferred metals to be deposited can be selected from Al, Ag, Au, Co, Cr, Cu, Fe, Ge, Mo, Nb, Ni, Os, Pd, Pt, Rh, Ru, Re, Ti and W.

Preferred metal oxides to be deposited are ZnO and SnO.

Preferred examples of such a metal compound or metal complex are selected from the group consisiting of palladium hexafluoro acetylacetonate, copper hexafluoro acetylacetonate, nickel di(cyclopentadienyl), iron di(cyclopentadienyl, methyl cyclopentadienyl platinum trimethyl, dimethyl gold acetylacetonate and di(cyclopentadienyl) platinum.

More preferred examples of metal compounds are methyl cyclopentadienyl platinum trimethyl and dimethyl gold acetylacetonate.

According to a more preferred embodiment of the present invention the deposited metal has a resistivity of less than 120 µΩ.cm and more preferably of less than 50 µΩ.cm.

Still more preferably the deposited metal is Ohmic or has a resistivity within a factor of 5 of the bulk material.

For example, according to a specific preferred embodiment of the method of the present invention methyl cyclopentadienyl platinum trimethyl can be converted along the equation

PtC₉H₁₆ + 20·H → 9CH₄ + Pt

in which the Pt is substantially pure.

The same result can also be reached via

PtC₉H₁₆ + 9O₂ → 9CO₂ + 8H₂ + Pt or

PtC₉H₁₆ + 5O₂ → 5CO₂ + 4CH₄ + Pt, and reactions in between these two.

It is noted that for carbonyl compounds the split into volatile and nonvolatile species can be exactly according to the particle balance as CO is split off and pumped away. However, it should be noted that in many cases (e.g. W(CO)₆) the split is not ideal and remainders of mainly carbon can stay in the deposition. In that case the H or O ions supplied from the ion beam can assist in removal of the remaining carbon (H) and removal of the remaining carbon in addition to full oxidation of the metal (O). So the beams have in this case the advantage of providing additional purification (H) or full oxidation (O) to the oxide form of the metal included.

According to specific embodiments the present invention the process applies for H+ ion beams a yield for deposition in the range of from 0,05 molecules/ion, and still more preferably from 0,1 molecules/ion to 2,0 molecules/ion, while for O⁺⁺ ion beams a yield for deposition is used in the range of from 0.5 to 10 molecules/ion According to other specific embodiments of the present invention an ion beam is used, which has energy in the range of from 0.2 keV to 50 keV and more preferably in the range of from 0.5 to 30 keV.

In the process of the present invention a local flux of molecules in the order of 10¹⁶ molecules/cm².s is applied while beam currents are used in the range of from 50 pA to 50 nA and preferably from 0.5 to 10 nA.

It will be appreciated that another aspect of the present invention is formed by shaped nano layers of high purity metal, obtainable by the hereinbefore specified process of the invention.

Although the description of the present invention above is mainly directed at methods for beam-induced deposition of low-resistivity material, it should be recognized that an apparatus performing the operation of such a method would further be within the scope of the present invention. Further, it should be recognized that embodiments of the present invention can be implemented via computer hardware, a combination of both hardware and software, or by computer instructions stored in a non-transitory computer-readable memory. The methods can be implemented in computer programs using standard programming techniques-including a non-transitory computer-readable storage medium configured with a computer program, where the storage medium so configured causes a computer to operate in a specific and predefined manner. Each program may be implemented in a high level procedural or object oriented programming language to communicate with a computer system. However, the programs can be implemented in assembly or machine language, if desired. In any case, the language can be a compiled or interpreted language. Moreover, the program can run on dedicated integrated circuits programmed for that purpose.

Although the present invention and its advantages have been described in detail, it should be understood that various changes, substitutions, and alterations can be made to the embodiments described herein without departing from the scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

### REFERENCES CITED IN THE DESCRIPTION

### Non-patent literature cited in the description

Wikipedia: "Electron beam induced deposition" Nanotechnology, 2011, Feb.4 22(5), Mulders J.J., Belova, L.M., Riazanova, A Functional Nanoscience, Beilstein Symposium, May 17-21, 2010, Bozen, Italy, Towards Electron Beam Induced Deposition; Improvements for Nanotechnology, Mulders, J.J.L and Botman, A, published June 13, 2011.

## Claims

1. A process for deposition of high purity metal or metal oxide nano layers comprising:
directing a precursor fluid toward a substrate surface, and irradiating the substrate surface with a focused ion beam in the presence of the precursor fluid, the precursor fluid dissociating in the presence of the particle beam to deposit a metal or metal oxide on the substrate surface, **characterized in that** the focused ion beam comprises hydrogen or oxygen ions.

2. A process according to claim 1, in which the precursor consists of a metal compound or metal complex, wherein at least a part of the carbon atoms are straightly bound to other carbon atoms.

3. A process according to the claims 1 and 2, in which the metal compound or metal complex comprises one or more alkyl groups, acetyl acetonate groups, cyclopentadienyl groups, β-diketonate groups, 2,2,6,6-tetramethyl heptane dionate groups or combinations thereof.

4. Process according to claim 3, wherein the metal compound or metal complex is selected from the group consisting of palladium hexafluoro acetyl acetonate, copper hexafluoro acetyl acetonate, nickel di(cyclopentadienyl), iron di(cyclopentadienyl), methyl cyclopentadienyl platinum trimethyl, dimethyl gold acetylacetonate and dicyclopentadienyl platinum.

5. Process according to claims 1-4, wherein the metal compound is methyl cyclopentadienyl platinum trimethyl or dimethyl gold acetyl.

6. Process according to the claims 1-5, wherein the metal to be deposited can be selected from Al, Ag, Au, Co, Cr, Cu, Fe, Ge, Mo, Nb, Ni, Os, Pd, Pt, Rh, Ru, Re, Ti and W.

7. Process according to claim 1, wherein the deposited metal has a resistivity of less than 120 µΩ.cm.

8. Process according to claim 7, wherein the deposited metal has a resistivity of less than 50 µΩ.cm.

9. Process according to claim 1, wherein the deposited metal is Ohmic or has a resistivity within a factor 5 of the bulk metal.

10. Process according to claim 1, wherein the yield for deposition for H⁺ ions is in the range of from 0,05 molecules/ion to 2,5 molecules/ion, and more preferably in the range of from 0,1 molecules/ion to 2,0 molecules/ion.

11. Process according to claim 1, wherein an ion beam, having an energy in the range of from 0,2 keV to 50 keV, is used.

12. Process according to claim 1, wherein the local flux of molecules is in the order of 10¹⁵-10¹⁹ molecules/cm².

13. Process according to claim 1, wherein the beam currents are in the range of from 50 pA to 50 nA.

14. Shaped nanolayers of high purity metal obtainable by the process of any of the claims 1-13.

15. A charged particle beam system configured and arranged to perform the process of claims 1-13.
